Europäisches Patentamt

European Patent Office

Office européen des brevets

(19)

(11) Numéro de publication: **0 361 611**

**A1**

(12) # DEMANDE DE BREVET EUROPEEN

(21) Numéro de dépôt: **89202408.4**

(51) Int. Cl.5: **H03H 11/04 , H03H 11/12**

(22) Date de dépôt: **25.09.89**

(30) Priorité: **30.09.88 FR 8812807**

(43) Date de publication de la demande:
**04.04.90 Bulletin 90/14**

(84) Etats contractants désignés:
**DE FR GB IT**

(71) Demandeur: **LABORATOIRES D'ELECTRONIQUE PHILIPS**
**1, Avenue Descartes**
**F-94450 Limeil Brévannes(FR)**

(84) **FR**

Demandeur: **N.V. Philips' Gloeilampenfabrieken**
**Groenewoudseweg 1**
**NL-5621 BA Eindhoven(NL)**

(84) **DE GB IT**

(72) Inventeur: **Deville, Yannick Société Civile S.P.I.D.**
**209 rue de l'Université**
**F-75007 Paris(FR)**

(74) Mandataire: **Jacquard, Philippe et al**
**SOCIETE CIVILE S.P.I.D. 209, rue de l'Université**
**F-75007 Paris(FR)**

(54) **Circuit actif pour hautes et hyperfréquences.**

(57) L'invention concerne un circuit actif pour hautes et hyperfréquences pouvant être utilisé comme filtre ou oscillateur et pouvant présenter une fréquence centrale élevée, un facteur Q également élevé ainsi qu'un bon compromis sélectivité-sensibilité. Il comporte un bloc (B) comprenant un filtre H(p), un amplificateur (g), et un sommateur (S) pour réaliser la sommation entre le signal de sortie ($V_{s3}$) du bloc (B) et un signal d'entrée ($V_e$) appliqué à l'entrée du bloc (B), le filtre présentant une fonction de transfert H(p) d'expression :

$$H(p) = G_1 \frac{\dfrac{p}{\omega_1} - 1}{\dfrac{p}{\omega_1} + 1}$$

avec p = variable de Laplace, et l'amplificateur utilisé à des fréquences proches de sa fréquence de coupure ayant une fonction de transfert passe-bas d'ordre 1.

FIG. 1

EP 0 361 611 A1

## CIRCUIT ACTIF POUR HAUTES ET HYPERFREQUENCES

La présente invention a pour objet un circuit actif passe-bande dans les domaines des hautes et des hyperfréquences comprenant un bloc comportant un filtre et un amplificateur, et un sommateur pour réaliser la sommation entre le signal de sortie du bloc et un signal d'entrée appliqué à l'entrée du circuit.

Un tel circuit actif, en l'espèce un filtre, est connu de la publication de J. TOW dans IEEE Spectrum, Décembre 1969 pp. 64-68, et intitulée "A step-by-step Active-filter Design". Une réalisation à fonction de transfert biquadratique est représentée à la figure 8, et comprend trois amplificateurs opérationnels en série, cette chaîne étant rétrobouclée. Un quatrième amplificateur opérationnel réalise la sommation de la sortie du premier amplificateur opérationnel et de l'entrée du circuit filtre. En hautes fréquences, le gain des amplificateurs est relativement faible et en outre la chaîne rebouclée est susceptible d'entraîner des oscillations du circuit. Un filtre du type passe-bande est représenté à la figure 6 et présente des caractéristiques similaires et donc les mêmes inconvénients.

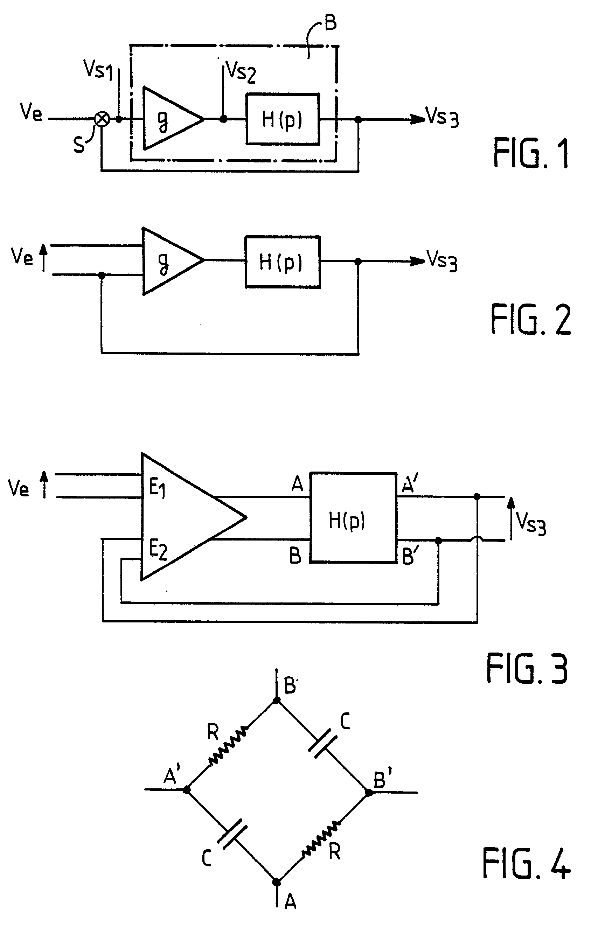

Un filtre est également connu de l'article de J. DAS et al "Twin T feedback filters" Int. J. Electronics 1968 vol. 25 n° 5 pp. 429-447 fig. 4a. Le filtre présente une fonction de transfert de type passe-bande, et une sélectivité Q qui vaut .

$$\left( \frac{k_0 + 1}{4} \right),$$

$k_0$ étant le gain de l'amplificateur. Or, tout amplificateur fonctionnant en hautes ou hyperfréquences, au voisinage de sa fréquence de coupure intrinsèque possède un gain relativement faible, ce qui conduit dans ce cas à une sélectivité faible du circuit de filtrage.

En outre, la structure pratique proposée utilise une cellule coupe-bande, mais ceci impose des valeurs bien précises des éléments. Si, comme dans le cas des circuits intégrés, les dispersions sur les éléments sont relativement élevées, la cellule est en général d'ordre 3, ce qui entraîne un risque d'oscillations non contrôlées du filtre complet.

De tels filtres sont enfin connus de l'article de R.P SALLEN et E.L. KEY paru dans IRE Trans. Circuits Theory vol CT-2 pp. 74-85, Mars 1955 et intitulé "A Practical Method of Designing RC Active Filters". Ces filtres se répartissent en deux classes. Dans la classe A, les filtres sont stables quelles que soient les valeurs des éléments, mais sont peu sélectifs, car la sélectivité maximale vaut $\frac{1}{2}\sqrt{k+1}$.

Dans la classe B, la sélectivité a pour valeur :

$$Q = \frac{\alpha}{\beta - K}$$

$\alpha$ et $\beta$ sont définis par les éléments du filtre et $\alpha$ est faible surtout pour les circuits intégrés où $\alpha \approx 1$. De ce fait, une sélectivité Q élevée ne peut être obtenue qu'avec des valeurs de $\beta$-K faibles, ce qui fait que la valeur de Q est très sensible aux dispersions des éléments actifs et passifs, avec un risque d'avoir $\beta$-K<O, c'est-à-dire que le filtre se mette à osciller de manière incontrôlée. En outre, aux fréquences élevées, le retard de phase apporté par l'élément amplificateur diminue de façon notable la fréquence centrale du filtre. L'élément amplificateur a en effet la fonction de transfert g suivante :

$$g = \frac{G_2}{\dfrac{p}{\omega_2} + 1}$$

La présente invention propose de remédier à ces inconvénients, en ce sens qu'elle propose un circuit actif présentant une bonne sélectivité, même avec un gain K faible, et une sélectivité améliorée pour des gains K élevés, et dont la stabilité n'est que peu affectée par les dispersions sur les éléments. Sa stabilité est relativement facile à contrôler ce qui fait qu'il se prête à des réalisations soit comme filtre, soit comme oscillateur.

Le circuit actif selon l'invention est dans ce but caractérisé en ce que le filtre présente une fonction de transfert H(p) qui a pour expression :

$$H(p) = G_1 \frac{\frac{p}{\omega_1} - 1}{\frac{p}{\omega_1} + 1} .$$

Le circuit présente une sélectivité Q élevée qui a pour valeur :

$$Q = \frac{\sqrt{\omega_1 \omega_2}}{\omega_1 + (1-k)\omega_2} \sqrt{1+k}$$

$$\text{avec } k = G_1 G_2$$

En outre, la fréquence centrale $f_p$ est élevée, car on a :

$$f_p \frac{\omega_p}{2\pi} = \frac{\sqrt{\omega_1 \omega_2}}{2\pi} \sqrt{1+k}$$

On obient donc un circuit sélectif dont la fonction de transfert T(p) est d'ordre 2 et dont le dénominateur présente un terme correspondant à une résonance à la fréquence $f_c$ On a :

$$T(p) = \frac{k}{1+k} \frac{\frac{p}{\omega_1} - 1}{(\frac{p}{\omega_p})^2 + 1/Q \frac{p}{\omega_p} + 1}$$

$$\text{avec } p = \text{variable de Laplace.}$$

Un tel filtre permet d'obtenir, en particulier pour un fonctionnement à des fréquences proches de la fréquence de coupure de l'amplificateur, une fréquence $f_p$ plus élevée que dans l'art antérieur, grâce au fait qu'on utilise la coupure de l'amplificateur et que $f_p$ contient le terme $\sqrt{1+k}$, et de réaliser également un meilleur compromis sélectivité-sensibilité car du fait que le numérateur de Q contient le terme $\sqrt{1+k}$, on n'a pas à rendre la différence de son dénominateur faible.

Selon un mode de réalisation avantageux, le circuit est caractérisé en ce que l'amplificateur comporte un étage à transistors à effet de champ comportant un premier, un deuxième, un troisième et un quatrième transistor ayant leur source commune et présentant deux entrées et une sortie différentiel les, à savoir la grille des premier et deuxième transistors d'une part et celle des troisième et quatrième transistors d'autre part, la source commune auxdits transistors étant connectée à une source de courant commandée par une première source de tension de commande, le drain des premier et troisième transistors, constituant un premier pôle de sortie différentielle, étant référencé à une première source de tension de polarisation, le drain des deuxième et quatrième transistors, constituant un deuxième pôle de sortie différentielle, étant référencé à une deuxième source de tension de polarisation, la grille des premier et deuxième transistors étant reliée à une deuxième source de tension de commande, et étant agencée pour recevoir un signal d'entrée du circuit.

La première tension de commande permet de régler le gain k de manière grossière, et la deuxième tension de commande permet un réglage fin du gain k.

Selon une variante préférée, le filtre comporte un pont à quatre branches dont deux premières branches opposées comportent respectivement un premier et un deuxième élément capacitif et dont deux deuxièmes branches opposées comportent au moins une première et une deuxième résistances variables, lesdites résistances variables étant ajustables grâce à une troisième source de tension de commande, deux premiers noeuds opposés du pont étant connectés à la grille respectivement des troisième et quatrième transistors, et les premier et deuxième pôles de sortie différentielle étant reliés respectivement à deux deuxièmes noeuds opposés du pont, éventuellement à travers un étage suiveur.

La troisième source de tension de commande permet d'ajuster la fréquence centrale $f_c$ du circuit.

L'invention sera mieux comprise à la lecture de la description qui va suivre, donnée à titre indicatif, en liaison avec les dessins qui représentent :

- la figure 1 un circuit de filtrage selon l'invention, dont les figures 2 et 3 sont des variantes,

- la figure 4 un mode de réalisation du filtre, et la figure 5 un mode de réalisation préféré de l'invention incorporant le filtre selon la figure 4.

Suivant la figure 1, un circuit actif, notamment un filtre, selon l'invention, comporte un bloc B comprenant un filtre H(p) et un amplificateur g ainsi qu'un sommateur pour réaliser la sommation entre le signal de sortie $V_{s3}$ du bloc B, et un signal d'entrée Ve appliqué à l'entrée du circuit. L'amplificateur g présente la fonction du transfert suivante :

$$g = \frac{G_2}{\frac{p}{\omega_2} + 1}$$

La fonction de transfert H(p) du filtre a pour expression :

$$H(p) = G_1 \frac{\frac{p}{\omega_1} - 1}{\frac{p}{\omega_1} + 1}$$

La fonction de transfert globale T(p) a alors pour expression :

$$T(p) = \frac{V_{s3}}{V_e} = \frac{k}{k+1} \cdot \frac{\frac{p}{\omega_1} - 1}{(\frac{p}{\omega p})^2 + \frac{1}{Q}(\frac{p}{\omega p}) + 1}$$

avec $K = G_1 G_2$

$$\omega p = \sqrt{\omega_1 \omega_2} \sqrt{k+1}$$

$$Q = \frac{\sqrt{\omega_1 \omega_2}}{\omega_1 + (1-k)\omega_2} \sqrt{k+1}$$

On obtient donc un circuit de filtrage sélectif dont le dénominateur de la fonction de transfert présente une résonance à ωp dont la valeur est plus élevée. Le facteur Q est élevé. On obtient un bon compromis sélectivité-sensibilité.

On a également :

$$T'(p) = \frac{V_{s1}}{V_e} = \frac{1}{k+1} \cdot \frac{(\frac{p}{\omega p}\sqrt{k+1})^2 + \frac{1}{Q_1}(\frac{p}{\omega p}\sqrt{k+1}) + 1}{(\frac{p}{\omega p})^2 + \frac{1}{Q}(\frac{p}{\omega p}) + 1}$$

avec $\quad Q_1 = \frac{\sqrt{\omega_1 \omega_2}}{\omega_1 + \omega_2}$

Selon la figure 2, l'amplificateur g et le sommateur sont fusionnés, ce qui permet d'éviter les retards de phase dus au sommateur et qui diminueraient la fréquence centrale du filtre.

Selon la figure 3, on utilise un amplificateur à deux entrées différentielles $E_1$ et $E_2$ et à une sortie différentielle. Le filtre H(p) se présente sous la forme d'un quadripôle (deux entrées A et B, deux sorties A' et B').

Selon la figure 4, le filtre H(p) consiste en un pont à quatre branches dont deux branches opposées présentent une résistance R, et les deux autres branches opposées présentent un condensateur C.

Il vient :

$G_1 = 1$

$\omega_1 = \frac{1}{RC}$

Les points A et B sont constitués par deux noeuds opposés du pont, et les points A′ et B′ par les deux autres noeuds opposés.

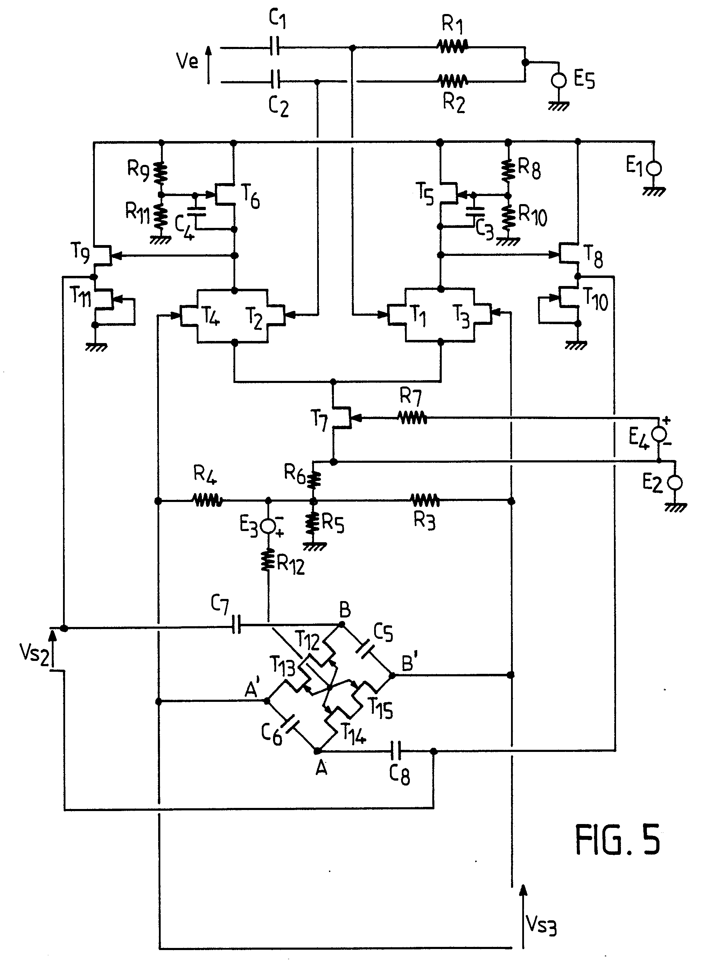

La figure 5 illustre un mode de réalisation préféré de l'invention incorporant le filtre de la figure 4, et mettant en oeuvre des transistors MESFET.

L'amplificateur est de type différentiel et comporte un première branche comportant deux transistors MESFET $T_1$ et $T_3$ dont la source et le drain sont interconnectés, et une deuxième branche comportant deux transistors MESFET $T_2$ et $T_4$ dont la source et le drain sont interconnectés. La source commune des quatre transistors $T_1$, $T_2$, $T_3$ et $T_4$ est connectée au drain d'un transistor $T_7$ dont la grille est connectée à un générateur de tension $E_4$, éventuellement à travers une résistance $R_7$, et dont la source est connectée à une source de tension $E_2$.

Le drain commun aux transistors $T_1$ et $T_3$ est connecté à la source d'un transistor MESFET $T_5$ dont le drain est connecté à une source de tension $E_1$. Un pont diviseur à résistances $R_8$ et $R_{10}$ est connecté entre la source de tension $E_1$ et le pôle de mode commun (masse). Le point commun aux résistances $R_8$ et $R_{10}$ est connecté à la grille du transistor qui forme une charge active. Un condensateur $C_3$ est connecté entre la grille et la source du transistor $T_5$, d'où une tension grille-source nulle en alternatif. Le transistor $T_5$ sert de charge active de polarisation des transistors $T_1$ et $T_3$.

Le drain commun aux transistors $T_2$ et $T_4$ est connecté à la source d'un transistor MESFET $T_6$ dont le drain est connecté à la source de tension $E_1$. Un pont diviseur à résistances $R_9$ et $R_{11}$ est connecté entre la source de tension $E_1$ et le pôle de mode commun. Le point commun aux résistances $R_9$ et $R_{11}$ est connecté à la grille du transistor $T_6$ qui forme une charge active. Un condensateur $C_4$ est connecté entre la grille et la source du transistor $T_5$, d'où une tension grille-source nulle en alternatif. Le transistor $T_6$ sert de charge active de polarisation des transistors $T_2$ et $T_4$.

La grille des transistors $T_1$ et $T_2$ reçoit la tension différentielle d'entrée $V_e$ à travers deux condensateurs de découplage, respectivement $C_1$ et $C_2$. Les grilles des transistors $T_1$ et $T_2$ sont référencées à une tension $E_5$ à travers des résistances respectivement $R_1$ et $R_2$. Les grilles des transistors $T_3$ et $T_4$ sont connectées aux points B′ et A′ du filtre de la figure 4 dont les résistances R sont constituées par le trajet drain-source de transistors MESFET à raison de deux transistors respectivement $T_{12}$ et $T_{13}$, et $T_{14}$ et $T_{15}$ pour chaque résistance R, ceci afin d'obtenir une valeur de résistance suffisamment élevée. Les grilles des quatre transistors $T_{12}$ à $T_{15}$ sont référencées au même potentiel $E_3$ à travers éventuellement une résistance série $R_{12}$. Les grilles des transistors $T_3$ et $T_4$ reçoivent ainsi grâce à $R_3$ et $R_4$ la tension de polarisation définie par le pont de résistances $R_5$ et $R_6$. Les drains communs aux transistors $T_1$ et $T_3$ d'une part, et $T_2$ et $T_4$ d'autre part sont connectés aux points A et B éventuellement à travers des étages suiveurs composés pour l'un des transistors MESFET $T_8$ et $T_{10}$, $T_8$ étant monté en source suiveuse et $T_{10}$ avec court-circuit source-grille, et pour les autres transistors MESFET $T_9$ et T11, $T_9$ étant monté en source suiveuse et $T_{11}$ avec court-circuit source-grille.

La tension $V_{S2}$ est disponible entre les points A et B du filtre, et la tension $V_{s3}$ entre les point A′ et B′ du filtre (grille des transistors $T_3$ et $T_4$). On utilise de préférence la sortie fournissant la tension $V_{s2}$, car elle présente l'avantage d'être sous faible impédance.

Le générateur de tension $E_4$ est agencé pour fournir une tension variable ce qui permet de faire varier K de manière grossière. Le générateur de tension $E_5$ est choisi de manière à délivrer une tension variable, de manière à ajuster finement la valeur de K. Le réglage par la tension $E_5$ est plus fin que par $E_4$ car une variation de $E_4$ se répercute entièrement sur la tension grille-source du transistor $T_7$, donc de $T_1$ à $T_4$, alors qu'une variation de $E_5$ se répercute directement sur la tension de grille des transistors $T_1$ et $T_2$, le courant dans l'amplificateur différentiel restant constant, de telle sorte que la tension grille-source de $T_1$ et $T_2$ varie moins que $E_5$. Enfin, le générateur de tension $E_3$ est choisi de manière à délivrer une tension variable, de manière à faire varier la valeur de R.

Le choix de la valeur de $E_3$ détermine $\omega_p$. Pour ajuster la valeur de Q, on modifie le gain K (c'est-à-dire $G_2$ puisque $G_1 = 1$), d'abord grossièrement en faisant varier $E_4$, puis finement en faisant varier $E_5$. Si $E_4$ augmente, Q augmente nettement. Si $E_5$ augmente, Q diminue un peu. Si on continue à augmenter Q, le circuit finit par devenir instable (Q<o), mais de manière contrôlable, ce qui permet un fonctionnement en oscillateur.

| Exemple 1 : | | | |
|---|---|---|---|
| $E_3$ = O V | $f_p$ = 3,22 GHz | $E_4 \simeq$ O V | $E_5 \simeq$ -3,8 V |
| $E_3$ = -1,8 V | $f_p$ = 1,52 GHz | $E_4 \simeq$ 1,8 V | $E_5 \simeq$ -2 V |

| Exemple 2 : | | | | | | |
|---|---|---|---|---|---|---|
| pour $f_p$ = 3,13 GHz : | | | | | | |
| a) $E_3$ = -0,2 V $E_5$ = -2,5 V | | | | | | |
| $E_4$(V) | -0,150 | -0,125 | -0,100 | -0,075 | -0,050 | -0,025 |
| Q | 32 | 42 | 60 | 104 | 413 | <0 |
| b) $E_3$ = -0,2 V $E_4$ = -0,1 V | | | | | | |
| $E_5$(V) | -2,400 | -2,450 | -2,475 | -2,500 | -2,525 | -2,550 | -2,600 |
| Q | 37 | 46 | 52 | 60 | 74 | 87 | 165 |

Le gain maximal du circuit est de l'ordre de 30dB pour des valeurs de Q de l'ordre de 50.

## Revendications

1. Circuit actif passe bande dans les domaines de hautes et hyperfréquences comprenant un bloc comportant un filtre et un amplificateur, et un sommateur pour réaliser la sommation entre le signal de sortie du bloc et un signal d'entrée appliqué à l'entrée du circuit, caractérisé en ce que le filtre présente une fonction de transfert H(p) qui a pour expression :

$$H(p) = G_1 \frac{\frac{p}{\omega_1} - 1}{\frac{p}{\omega_1} + 1}$$

2. Circuit actif selon la revendication 1 caractérisé en ce que l'amplificateur comporte un étage à transistors à effet de champ comportant un premier ($T_1$), un deuxième ($T_2$), un troisième ($T_3$) et un quatrième ($T_4$) transistor ayant leur source commune et présentant deux entrées différentielles, à savoir la grille des premier ($T_1$) et deuxième ($T_2$) transistors d'une part et celle des troisième ($T_3$) et quatrième ($T_4$) transistors d'autre part, la source commune auxdits transistors ($T_1$, $T_2$, $T_3$, $T_4$) étant connectée à une source de courant ($T_7$, $R_7$) commandée par une première source de tension de commande ($E_4$), le drain des premier ($T_1$) et troisième ($T_3$) transistors, constituant un premier pôle de sortie différentielle, étant référencé à une première source de tension de polarisation, le drain des deuxième ($T_2$) et quatrième ($T_4$) transistors, constituant un deuxième pôle de sortie différentielle, étant référencé à une deuxième source de tension de polarisation, la grille des premier et deuxième transistors étant reliée à une deuxième source de tension de commande ($E_5$), et étant agencée pour recevoir un signal d'entrée ($V_e$) du circuit.

3. Circuit actif selon une des revendication 1 ou 2 caractérisé en ce que le filtre comporte un pont à quatre branches dont deux premières branches opposées comportent respectivement un premier et un deuxième éléments capacitifs (C) et dont deux deuxièmes branches opposées comportent au moins une première et une deuxième résistances variables (R), lesdites résistances variables étant ajustables grâce à une troisième source de tension de commande ($E_3$), deux premiers noeuds opposé (B', A') du pont étant connectés à la grille repectivement des troisième ($T_3$) et quatrième ($T_4$) transistors, et les premier et deuxième pôles sortie différentiels étant reliés respectivement à deux deuxièmes noeuds opposés du point (A, B).

4. Circuit actif selon la revendication 3 caractérisé en ce qu'un premier ($T_8$, $T_{10}$) et un deuxième ($T_9$, $T_{11}$) étages suiveurs sont intercalés entre respectivement les premier et deuxième pôles de sortie différentiels et les deux deuxièmes noeuds opposés du pont (A, B).

FIG. 1

FIG. 2

FIG. 3

FIG. 4

FIG. 5

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| A | IEEE TRANSACTIONS ON CIRCUITS AND SYSTEMS, vol. CAS-33, no. 8, août 1986, pages 838-840, IEEE, New York, US; D.J. COMER: "High-frequency narrow-band active filters" * En entier * --- | 1 | H 03 H 11/04 H 03 H 11/12 |
| P,A | EP-A-0 314 235 (LABORATOIRES D'ELECTRONIQUE ET PHYSIQUE APPLIQUEE) * En entier * ----- | 1-4 | |

|  | DOMAINES TECHNIQUES RECHERCHES (Int. Cl.5) |
|---|---|
|  | H 03 H |

Le présent rapport a été établi pour toutes les revendications

| Lieu de la recherche | Date d'achèvement de la recherche | Examinateur |
|---|---|---|
| LA HAYE | 27-12-1989 | COPPIETERS C. |